# EUROPÄISCHE PATENTANMELDUNG

(11) **EP 1 249 869 A2**
(43) Veröffentlichungstag der Anmeldung: **16.10.2002**
(21) Anmeldenummer: 02008005.7
(22) Anmeldetag: 10.04.2002
(51) Int. Cl.: H01L 23/373

(54) **Anordnung zur Kühlung eines Leistungs-Halbleiterelementes**

(30) Priorität: 12.04.2001 DE 10118384
(71) Anmelder: SIEMENS AKTIENGESELLSCHAFT, 80333 München (DE)
(72) Erfinder: Mattmann, Erich, 55262 Heidesheim (DE); Thyzel, Bernd, 61479 Schlossborn (DE)

(57) **Zusammenfassung**

Bei einer Anordnung zur Kühlung eines Leistungs-Halbleiterelementes ist vorgesehen, daß auf einem Aluminiumträger eine Isolierschicht aus keramischem Werkstoff aufgebracht ist, auf welcher das Leistungs-Halbleiterelement angeordnet ist. Die Isolierschicht kann mit einem plasmachemischen Verfahren aufgebracht sein.

## Beschreibung

### Anordnung zur Kühlung eines Leistungs-Halbleiterelementes

Die Erfindung betrifft eine Anordnung zur Kühlung eines Leistungs-Halbleiterelementes.

Zur Ableitung der in Leistungs-Halbleiterelementen entstehenden Wärme werden meist Kühlkörper aus Aluminium verwendet. Dazu ist eine gut wärmeleitende Verbindung zwischen dem Leistungs-Halbleiterelement und dem Kühlkörper erforderlich, wobei in der Regel zusätzlich eine elektrische Isolierung benötigt wird. Um den Wärmewiderstand zwischen dem Leistungs-Halbleiterelement und dem Kühlkörper möglichst gering zu halten, sind verschiedene Pasten und Kleber, die im Bedarfsfall auch leitend sind, bekanntgeworden. Dennoch haben die Wärmeübertragungsmedien den größten Anteil am Wärmewiderstand des gesamten Aufbaus.

Aufgabe der vorliegenden Erfindung ist es, einen guten Wärmeübergang zwischen dem Leistungs-Halbleiterelement und dem Kühlkörper bei gleichzeitiger zuverlässiger elektrischer Isolierung sicherzustellen.

Diese Aufgabe wird erfindungsgemäß dadurch gelöst, daß auf einem Aluminiumträger eine Isolierschicht aus keramischem Werkstoff aufgebracht ist, auf welcher das Leistungs-Halbleiterelement angeordnet ist. Vorzugsweise ist dabei die Isolierschicht mit einem plasma-chemischen Verfahren aufgebracht. Eine Schichtstärke von vorzugsweise 5 æm bis 30 æm ermöglicht eine ausreichende elektrische Isolation bei einem möglichst geringen Wärmewiderstand.

Eine vorteilhafte Ausgestaltung der erfindungsgemäßen Anordnung besteht darin, daß das Leistungs-Halbleiterelement auf einer leitenden Schicht auf der Isolierschicht angeordnet ist. Die leitende Schicht kann eine übliche direkt - beispielsweise durch Siebdruck bzw. Dosieren - oder indirekt mit Abziehfolie aufgebrachte Leiterbahn sein. Zur Vervollständigung der das Leistungs-Halbleiterelement beinhaltenden Schaltung können in gleicher Weise auch weitere Leiterbahnen vorgesehen sein.

Die erfindungsgemäße Anordnung hat den Vorteil einer besseren thermischen Anbindung des Leistungs-Halbleiterelementes an den Kühlkörper und damit einer Reduzierung des Wärmewiderstandes. Es können bei gleichen Leistungsanforderungen kleinere und damit kostengünstigere Leistungs-Halbleiterelemente eingesetzt werden. Die Erfindung ermöglicht weiterhin eine Mischung zwischen Standardelektronik und Direktschicht auf Aluminium, wobei zur Verbindung Dickdrahtbonden geeignet ist.

Weitere vorteilhafte Ausgestaltungen bestehen darin, daß die leitende Schicht mit bei niedrigen Temperaturen schmelzenden Dickschichtpasten oder mit elektrisch leitfähigem Klebstoff hergestellt ist.

Die erfindungsgemäße Anordnung kann auch dahingehend weiter gebildet sein, daß auf der Isolierschicht ferner Schichtwiderstände angeordnet sind, die aus Polymer-Pasten bestehen.

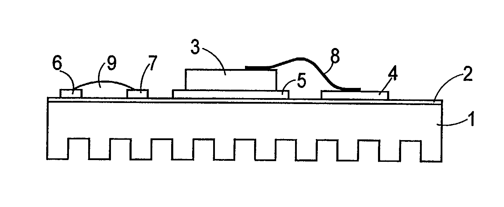

Die Erfindung läßt zahlreiche Ausführungsformen zu. Eine davon ist schematisch in der Zeichnung dargestellt und nachfolgend beschrieben.

Die Zeichnung stellt das Ausführungsbeispiel schematisch dar, wobei wegen der besseren Erkennbarkeit die Schichten stärker als in Wirklichkeit dargestellt sind. Auf einem Kühlkörper 1 aus Aluminium ist eine isolierende Schicht 2 aus Keramik aufgebracht. Darauf befindet sich eine leitende Schicht in Form von Leiterbahnen 4 bis 6. Die Leiterbahn 5 trägt das Leistungs-Halbleiterelement 3, das elektrisch einerseits - vorzugsweise durch Löten - mit der Leiterbahn 5 und andererseits über einen Bonddraht 8 mit der Leiterbahn 4 verbunden ist.

Die weiteren Leiterbahnen 6 und 7 sind über einen Dickschichtwiderstand 9 miteinander verbunden.

## Patentansprüche

1. Anordnung zur Kühlung eines Leistungs-Halbleiterelementes,
**dadurch gekennzeichnet, daß**
auf einem Aluminiumträger (1) eine Isolierschicht (2) aus keramischem Werkstoff aufgebracht ist, auf welcher das Leistungs-Halbleiterelement (3) angeordnet ist.

2. Anordnung nach Anspruch 1,
**dadurch gekennzeichnet, daß**
die Isolierschicht (2) mit einem plasma-chemischen Verfahren aufgebracht ist.

3. Anordnung nach einem der Ansprüche 1 oder 2,
**dadurch gekennzeichnet, daß**
das Leistungs-Halbleiterelement (3) auf einer leitenden Schicht (5) auf der Isolierschicht (2) angeordnet ist.

4. Anordnung nach Anspruch 3,
**dadurch gekennzeichnet, daß**
die leitende Schicht (5) mit bei niedrigen Temperaturen schmelzenden Dickschichtpasten hergestellt ist.

5. Anordnung nach Anspruch 3,
**dadurch gekennzeichnet, daß**
die leitende Schicht (5) mit elektrisch leitfähigem Klebstoff hergestellt ist.

6. Anordnung nach einem der vorhergehenden Ansprüche,
**dadurch gekennzeichnet, daß**
auf der Isolierschicht (2) ferner Schichtwiderstände (9) angeordnet sind, die aus Polymer-Pasten bestehen.
